# EUROPÄISCHE PATENTANMELDUNG

(11) **EP 3 886 179 A1**
(43) Veröffentlichungstag der Anmeldung: **29.09.2021**
(21) Anmeldenummer: 21000071.7
(22) Anmeldetag: 12.03.2021
(51) Int. Cl.: H01L 29/861, H01L 21/329, H01L 29/06, H01L 29/20, H01L 29/205, H01L 21/02

(54) **STAPELFÖRMIGE HOCHSPERRENDE INGAAS-HALBLEITERLEISTUNGSDIODE**

(30) Priorität: 20.03.2020 DE 102020001843
(71) Anmelder: AZUR SPACE Solar Power GmbH, 74072 Heilbronn (DE)
(72) Erfinder: Wierzkowski, Thorsten, 74074 Heilbronn (DE); Fuhrmann, Daniel, 74081 Heilbronn (DE)
(74) Vertreter: Koch Müller Patentanwaltsgesellschaft mbH

(57) **Zusammenfassung**

Stapelförmige hochsperrende III-V-Halbleiterleistungsdiode und Herstellungsverfahren, wobei die III-V-Halbleiterleistungsdiode ein erstes hochdotiertes Halbleiterkontaktgebiet, ein unterhalb des ersten Halbleiterkontaktgebiets angeordnetes niedrig dotiertes Halbleiterdriftgebiet, ein unterhalb des Halbleiterdriftgebiets angeordnetes hochdotiertes zweites Halbleiterkontaktgebiet und zwei Anschlusskontaktschichten aufweist, zumindest das erste Halbleiterkontaktgebiet einen Kernstapel ausbilden, der Kernstapel entlang der Seitenfläche von einem dielektrischen Rahmenbereich umschlossen ist, die Oberseite bzw. Unterste des Kernstapels und des dielektrischen Rahmenbereichs miteinander abschließen oder zueinander eine Stufe ausbilden und unterhalb des ersten Halbleiterkontaktgebiets angeordnete Halbleitergebiete der III-V-Halbleiterleistungsdiode jeweils entweder von dem Kernstapel umfasst sind oder einen Trägerbereich ausbilden einen Trägerbereich ausbilden, wobei der Trägerbereich unterhalb des Kernstapels und des Rahmenbereichs angeordnet und mit einer gemeinsamen Unterseite, gebildet aus der Unterseite des dielektrischen Rahmenbereichs und der Unterseite des Kernstapels, stoffschlüssig verbunden ist.

## Beschreibung

Die Erfindung betrifft eine stapelförmige hochsperrende InGaAs-Leistungshalbleiterdiode.

Aus "GaAs Power Devices" von German Ashkinazi, ISBN 965-7094-19-4, Seite 8 und 9 ist eine hochspannungsfeste PIN-Halbleiterdiode aus GaAs bekannt.

Stapelförmige hochsperrende InGaAs-Halbleiterleistungsdioden und entsprechende Herstellungsverfahren sind aus den Druckschriften DE 10 2016 013 540 A1, DE 10 2016 013 541 A1, DE 10 2016 015 056 A1, DE 10 2017 002 935 A1 und DE 10 2017 002 936 A1 bekannt.

Gattungsgemäße Dioden weisen Durchbruchspannungen oberhalb von 200V auf und sollten neben einer niedrigen Vorwärtsspannung und einen geringen Serienwiderstand aufweisen, um die Verlustleistung zu reduzieren. Des Weiteren sollten die Dioden in Sperrrichtung möglichst geringe Leckströme von unterhalb 1 µA aufweisen.

Die Halbleiterbauelemente werden meist noch auf Waferebene durch Passivierungs- und/oder Schutzschichten geschützt.

Entsprechende Verfahren für III-V-Halbleiterbauelemente sind beispielsweise aus "Passivaton of GaAs in alcohol solutions of ammonium sulfide", V. N. Bessolov et al., Semiconductors, Vol. 31, No. 11, pp. 1350-1356, ISSN 1063-7826, 1997 oder aus "Ammonium sulfide passivation for AlGaAs/GaAs buried heterostructure laser fabrication process", T. Tamanukl et al., Japanese Journal of Applied Physics, Part 1, Vol. 30, No. 3, pp. 499-500, ISSN 0021-4922, 1991 oder aus "Simplified Surface Preparation for GaAs Passivation Using Atomic Layer-Deposited High-/ Dielectrics", Yi Xuan et al., IEEE Transactions on Electron Devices, Vol. 54, No. 8, 2007 bekannt.

Zur Vereinzelung werden typischerweise in einem ersten Mesa-Prozess Gräben geätzt und anschließend der unter den Gräben liegende Bereich durch Sägen durchtrennt. Die Gräben werden typischerweise im Weiteren passiviert.

Es ist außerdem bekannt, Nano-Strukturen durch selektives Wachsen auf einem mit einer strukturierten SiO₂-Maskenschicht bedeckten Wafer zu erzeugen. Verschiedene Verfahren werden beispielsweise in "Nanoimprint and selective-area MOVPE for growth of GaAs/InAs core/shell nanowires", F. Haas et al, Nanotechnology, Vol. 24, No. 8, 085603, 2013 oder "III/V nano ridge structures for optical applications on patterned 300 mm silicon substrate", B. Kunert et al., Appl. Phys. Lett. 109, 091101, 2016, beschrieben.

Vor diesem Hintergrund besteht die Aufgabe der Erfindung darin, eine Vorrichtung anzugeben, die den Stand der Technik weiterbildet.

Die Aufgabe wird durch eine Vorrichtung mit den Merkmalen des Patentanspruchs 1 sowie durch ein Verfahren mit den Merkmalen des Patentanspruchs 11 gelöst. Vorteilhafte Ausgestaltungen der Erfindung sind Gegenstand von Unteransprüchen.

Gemäß dem Gegenstand der Erfindung wird eine stapelförmige hochsperrende III-V-Halbleiterleistungsdiode bereitgestellt, aufweisend ein erstes hochdotiertes Halbleiterkontaktgebiet eines ersten Leitfähigkeitstyps mit einer Dotierstoffkonzentration von mindestens 1•10¹⁸ cm⁻³ und mit einer ersten Gitterkonstanten.

Unterhalb des ersten Halbleiterkontaktgebiets ist ein niedrig dotiertes Halbleiterdriftgebiet des ersten Leitfähigkeitstyps oder eines zweiten Leitfähigkeitstyps mit einer Dotierstoffkonzentration von 8•10¹¹ - 1•10¹⁵ cm⁻³ angeordnet, wobei das Halbleiterdriftgebiet die erste Gitterkonstante und eine Schichtdicke zwischen 10 µm - 200 µm aufweist.

Unterhalb des Halbleiterdriftgebiets ist ein hochdotiertes zweites Halbleiterkontaktgebiet des zweiten Leitfähigkeitstyps mit einer Dotierstoffkonzentration von mindestens 5•10¹⁷ cm⁻³ angeordnet, wobei das zweites Halbleiterkontaktgebiet die erste Gitterkonstante oder eine zweite Gitterkonstante aufweist.

Eine erste metallische Anschlusskontaktschicht ist zumindest gebietsweise auf einer Oberseite des ersten Halbleiterkontaktgebiets ausgebildet und stoffschlüssig mit der Oberseite des ersten Halbleiterkontaktgebiets verbunden.

Eine zweite metallische Anschlusskontaktschicht Ist zumindest gebietsweise unterhalb einer Unterseite des zweiten Halbleiterkontaktgebiets ausgebildet und beispielsweise stoffschlüssig mit der Unterseite des zweiten Halbleiterkontaktgebiets oder einer zwischen dem zweiten Halbleiterkontaktgebiet und der zweiten metallischen Anschlusskontaktschicht angeordneten Halbleiterschicht, z.B. einer Substratschicht oder einer Pufferschicht, verbunden.

Zumindest das erste Halbleiterkontaktgebiet bildet einen Kernstapel aus. Der Kernstapel weist eine Oberseite und eine Unterseite und eine sich von der Oberseite bis zu der Unterseite erstreckende Seitenfläche aus.

Außerdem weist die III-V-Halbleiterleistungsdlode einen den Kernstapel entlang der Seitenfläche umschließenden dielektrischen Rahmenbereich mit einer Oberseite und einer Unterseite auf.

Die Oberseite des Kernstapels schließt mit der Oberseite des dielektrischen Rahmenbereichs ab oder bildet zu der Oberseite des dielektrischen Rahmenbereichs eine erste Stufe aus.

Die Unterseite des Kemstapels schließt mit der Unterseite des dielektrischen Rahmenbereichs ab oder bildet zu der Unterseite des dielektrischen Rahmenbereichs eine zweite Stufe aus.

Unterhalb des ersten Halbleiterkontaktgebiets angeordnete Halbleitergebiete der III-V-Halbleiterleistungsdiode sind jeweils entweer von dem Kernstapel umfasst oder bilden einen Trägerbereich aus, wobei der Trägerbereich unterhalb des Kernstapels und des Rahmenbereichs angeordnet und mit einer gemeinsamen Unterseite, gebildet aus der Unterseite des dielektrischen Rahmenbereichs und der Unterseite des Kernstapels, stoffschlüssig verbunden ist.

Anders ausgedrückt weist die III-V-Halbleiterleistungsdiode immer einen von dem Rahmenbereich umgebenen Kernstapel auf und ein darunter angeordneter Trägerbereich ist optional.

Beispielsweise bilden sowohl das Driftgebiet als auch das zweite Halbleiterkontaktgebiet den Kernstapel mit aus, so dass die III-V-Halbleiterleistungsdiode entweder keinen Trägerbereich oder einen aus einer weiteren Halbleiterschicht, z.B. einem Substrat ausgebildeten Trägerbereich aufweist. In einer alternativen Ausführungsform ist beispielsweise das Driftgebiet als Teil des Kernstapels ausgebildet und die III-V-Halbleiterleistungsdiode weist einen zumindest aus dem zweiten Halbleiterkontaktgebiet ausgebildeten Trägerbereich auf.

Alternativ umfasst der Kernstapel nur das erste Halbleiterkontaktgebiet oder gegebenenfalls noch eine weitere Halbleiterzwischenschicht, wobei sowohl das Driftgebiet als auch das zweite Halbleiterkontaktgebiet in dem Trägerbereich ausgebildet sind.

Es sei angemerkt, dass die metallischen Anschlusskontaktschichten jeweils elektrisch sehr gut leitfähig sind.

Vorzugsweise bestehen die metallischen Anschlusskontaktschichten aus einer oder mehreren Metallschichten, wobei die Metallschichten bevorzugt Ge und/oder Au und/oder Pd und/oder Ag umfassen. Die metallischen Anschlusskontaktschichten stellen einen elektrisch niederohmigen Kontakt zu den hochdotierten Halbleiterkontaktgebieten her.

Eine möglichst große insbesondere ganzflächige Ausbildung der zweiten metallischen Anschlusskontaktschicht an der Unterseite verbessert die thermische Ankopplung an eine Unterlage und verringert den Widerstand des Bauelements. Als ganzflächige Ausbildung wird eine Überdeckung von mindestens 70% oder von mindestens 80% der Unterseite des zweiten Halbleiterkontaktgebiets bezeichnet.

Alternativ ist die zweite metallische Anschlusskontaktschicht als Punkte bzw. begrenzte Flächenabschnitte oder auch fingerförmig ausgebildet.

In einer weiteren alternativen Ausführungsform weist die III-V-Halbleiterleistungsdiode keinen Trägerbereich auf und die zweite metallische Anschlusskontaktschicht ist ganzflächig auf der Unterseite der III-V-Halbleiterleistungsdiode ausgebildet, d.h. die zweite metallische Anschlusskontaktschicht bedeckt eine gemeinsame Unterseite, gebildet aus der Unterseite des Kernstapels und der Unterseite des Rahmenbereichs.

Des Weiteren versteht es sich, dass die metallischen Anschlusskontaktschichten vorzugsweise mittels Bonddrähten mit Kontaktfingern, den sogenannten Pins, verschaltet sind, indem die Halbleiterleistungsdioden auf einem Träger beispielsweise in Form eines Leadframes angeordnet sind.

Auch sei angemerkt, dass der Ausdruck "Halbleiterschicht" bzw. "Halbleiterkontaktschicht" mit dem Ausdruck "Halbleitergebiet" bzw. "Halbleiterkontaktgebiet" oder "Halbleiterkontakt" bzw. "Halbleiterkontaktbereich" vorzugsweise synonym verwendet wird.

Es versteht sich, dass alle Halbleitergebiete der Leistungsdiode, also insbesondere das erste und zweite Halbleiterkontaktgebiet und das Driftgebiet, bevorzugt schichtförmig, insbesondere als plane Schichten ausgebildet sind, also eine plane oder im Wesentlichen plane Oberseite und Unterseite aufweisen.

Insbesondere das erste und/oder das zweite Halbleiterkontaktgebiet sind In einer alternativen Ausführungsform wannenförmig ausgebildet. Es versteht sich weiter, dass die wannenförmigen Gebiete bevorzugt von einer Oberseite einer anderen planen Halbleiterschicht in diese plane Halbleiterschicht hineinreichen.

Bevorzugt wird ein wannenförmiges Halbleiterkontaktgebiet innerhalb eines Bereichs eines schichtförmig ausgebildeten Driftgebiets durch Einbringen von Dotierstoffen in diesen Bereich erzeugt, wobei der Bereich bevorzugt wannenförmig in das Driftgebiet hineinreicht.

Alternativ wird durch Implantation von Dotierstoffen ein schichtförmiges Halbleiterkontaktgebiet in einem Driftgebiet erzeugt, z.B. wird eine sich an die Oberseite des Driftgebiets anschließende Schicht einer gewünschten Tiefe durch Implantation in das Halbleiterkontaktgebiet umgewandelt.

Alle Halbleiterschichten der Leistungsdiode sind bevorzugt epitaktisch, z.B. mittels MOVPE oder mittel LPE oder mittels CVD, oder durch Implantation oder Diffusion erzeugt. Alternativ oder ergänzend sind eine oder mehrere Schichten des Trägerbereichs mittels eines Wafer-Bonds miteinander verbunden.

Es versteht sich, dass nur die Halbleitergebiete bzw. Halbleiterschichten oder zumindest ein Großteil der Halbleitergebiet bzw. Halbleiterschichten der hochsperrenden III-V-Halbleiterdiode aus III-V-Materialien, z.B. GaAs, In-GaP, InGaAs, AIGaAs oder InP, bestehen.

Alternativ umfasst die hochsperrende III-V-Halbleiterdiode zusätzlich Halbleiterschichten aus anderen Halbleitermaterialien oder zusätzliche Schichten aus anderen nicht-Halbleiter-Materialien.

III-V-Halbleiter, insbesondere GaAs oder InGaAs, liefern eine besonders hohe Ladungsträgerbeweglichkeit.

Außerdem versteht es sich, dass ein aus einem III-V-Material bestehendes Halbleitergebiet bzw. eine Halbleiterschicht nur im Wesentlichen aus III-V-Material bestehen muss bzw. neben einem III-V-Material, also einem Material welches ein Element oder mehrere Elemente der III. und/oder V. Hauptgruppe umfasst, gegebenenfalls noch Verunreinigungen und/oder Dotierstoffe aufweisen kann.

Entsprechendes gilt für ein aus GaAs oder aus InGaAs oder einer anderen ausdrücklich genannten Materialkombination bestehenden Halbleitergebiet bzw. Halbleiterschicht.

Weist eine Schicht eine ausdrücklich genannte Materialkombination auf, so wird damit ausgedrückt, dass das Material der Schicht im Wesentlichen aus einer Verbindung der ausdrücklich genannten Materialien und gegebenenfalls weiteren Elementen der III. und/oder V. Hauptgruppe besteht. Eine GaAs aufweisende Schicht kann also beispielsweise ein GaAsP-Schicht oder AlGaAs Schicht sein.

Es versteht sich auch, dass die hochsperrende III-V-Halbleiterdiode mit einer n-auf-p oder einer p-auf-n Struktur ausgebildet sein kann. Entsprechend ist entweder der erste Leitfähigkeitstyp n und der zweite Leitfähigkeitstyp p oder vice versa.

Die Begriffe "unten" und "*oben" bzw. "unterhalb" und "oberhalb" dienen lediglich dazu, die Anordnung der einzelnen Schichten und Gebiete relativ zueinander zu beschreiben und geben keine absolute Richtung an.

Es wird angemerkt, dass der dielektrische Rahmenbereich aus einem dielektrischen Material bzw. einem dielektrische Eigenschaften aufweisenden Material besteht. Bevorzugt besteht der dielektrische Rahmenbereich aus SiₓO_{y}, z.B. SiO₂, oder aus SiₓN_{y}, z.B. SiN, oder aus AlₓO_{y} oder aus TaₓO_{y} oder aus TiₓO_{y} oder aus HfₓO_{y}. Alternativ weist der Rahmenbereich SiₓO_{y} oder SiₓN_{y} oder AlₓO_{y} oder TaₓO_{y} oder TiₓO_{y} oder HfₓO_{y} auf. In einer anderen Ausführungsform ist der dielektrische Rahmenbereich als Oxid ausgebildet, z.B. aus Al₂O₃ oder Ta₂O₅ oder TiO₂ oder HfO₂ oder eine seltene Erde aufweisend.

Der dielektrische Rahmenbereich ist bevorzugt schichtförmig mit einer den Kernstapel aufnehmenden Durchgangsöffnung ausgebildet.

Die so entstandene gemeinsame Schicht weist beispielsweise eine plane gemeinsame Oberseite und/oder eine plane gemeinsame Unterseite auf. Alternativ ragt der Kernstapel über die Oberseite und/oder die Unterseite des dielektrischen Rahmenbereichs hinaus, so dass sich am Übergang von dem dielektrischen Rahmenbereich zu dem Kernstapel eine ansteigende Stufe ausbildet.

In einer weiteren alternativen Ausführungsform reicht die Oberseite des Kernstapels nicht bis zu der Oberseite des dielektrischen Rahmenbereichs, so dass sich bei dem Übergang von der Oberseite des dielektrischen Rahmenbereichs zu der Oberseite des Kernstapels eine absteigende Stufe ausbildet.

Die so entstandene gemeinsame Schicht aus Rahmenbereich und Kernstapel kann außerdem auf einem Trägerbereich angeordnet sein, so dass eine von der Unterseite des Rahmens und der Unterseite des Kernstapels gebildete gemeinsame Unterseite (die Unterseite der gemeinsamen Schicht) stoffschlüssig mit der Oberseite des Trägerbereichs verbunden ist.

Vorzugsweise schließt die äußere Seitenfläche des Rahmenbereichs mit den Seitenflächen des Trägerbereichs ab, d.h. der Trägerbereich weist einen Durchmesser auf, der der Summe aus dem Durchmessers des Kernstapels und dem zweifachen der Wandstärke des Rahmenbereichs entspricht.

Der Rahmenbereich stellt einen ausreichenden Schutz bzw. eine ausreichende Passivierung der Seitenflächen bzw. des p-n Übergangs dar, so dass auf weitere Passivierungsschichten verzichtet werden kann. Leckströme werden zuverlässig unterdrückt und eine hohe Durchbruchspannung und Effizienz erreicht.

Ein Vorteil ist, dass die epitaktische Abscheidung der III-V Halbleiterschichten innerhalb des dielektrischen Rahmenbereichs die Ausbildung von Oberflächenzuständen, die sich normalerweise durch den in Luft enthaltenden Sauerstoff an der Halbleiteroberfläche bilden und zu reduzierten Durchbruchspannungen und Bauelementeffizienzverminderungen führen, verhindert. Zudem bleibt der pn-Übergang in dem Rahmenbereich geschützt, so dass ein Eindringen von Feuchtigkeit sehr zuverlässig verhindert wird. Gerade Feuchtigkeit führt zu höheren Leckströmen bzw. geringen Durchbruchspannungen, so dass ein Eindringen von Feuchtigkeit besonders bei hochsperrenden Bauteilen verhindert werden muss.

Darüber hinaus ermöglicht der Rahmenbereich das separierte Erzeugen einzelner Leistungsdioden durch selektives Wachstum. Hierdurch ist ein besonders einfaches Vereinzeln der erfindungsgemäßen III-V-Halbleiterleistungsdioden allein durch Sägen möglich.

Ein zusätzliches Ätzen vor dem Sägen erübrigt sich. Es ist eine verhältnismäßig günstige Herstellung möglich. Im Vergleich zu SiC sind die Herstellungskosten von III-V-Bauelementen generell günstiger.

Auch lassen sich mit den III-V Halbleiterleistungsdioden im Vergleich zu Si höhere Temperaturen an den p/n-Übergängen erreichen, ohne dass die III-V Halbleiterdioden zerstört werden. So lassen sich III-V Halbleiterdioden bei Temperaturen von bis zu 300°C, d.h. auch in heißen Umgebungen, einsetzten.

In einer Weiterbildung weist die III-V-Halbleiterleistungsdiode zwischen dem ersten Halbleiterkontaktgebiet und dem Halbleiterdriftgebiet eine Halbleiterzwischenschicht des ersten Leitfähigkeitstyps mit einer Dotierstoffkonzentration von 8•10¹² - 1•10¹⁶ cm⁻³ auf. Es versteht sich, dass die Halbleiterzwischenschicht als Teil des Kernstapels und/oder als Teil des Trägerbereichs ausgebildet ist.

In einer anderen Ausführungsform weist die III-V-Halbleiterleistungsdiode alternativ oder ergänzend zwischen dem zweiten Halbleiterkontaktgebiet und dem Halbleiterdriftgebiet eine Halbleiterzwischenschicht des zweiten Leitfähigkeitstyps mit einer Dotierstoffkonzentration von 8•10¹² - 1•10¹⁶ cm⁻³ auf. Es versteht sich, dass die Halbleiterzwischenschicht als Teil des Kernstapels und/oder als Teil des Trägerbereichs ausgebildet ist.

In einer weiteren Ausführungsform weist die III-V-Halbleiterleistungsdiode eine hochdotierte metamorphe Pufferschichtfolge auf, wobei die metamorphe Pufferschichtschichtfolge zwischen dem Halbleiterdriftgebiet und dem zweiten Halbleiterkontaktgebiet angeordnet ist, eine Dotierstoffkonzentration größer als 5•10¹⁷ cm⁻³ und eine Schichtdicke oberhalb 0,5 µm und kleiner als 20 µm aufweist, von dem ersten Leitfähigkeitstyp oder dem zweiten Leitfähigkeitstyp ist und an einer dem Halbleiterdriftgebiet zugewandten Oberseite die erste Gitterkonstante und an einer dem zweiten Halbleiterkontaktgebiet zugewandten Unterseite die zweite Gitterkonstante aufweist und das zweite Halbleiterkontaktgebiet die zweite Gitterkonstante aufweist.

Die Pufferschichtfolge ist beispielsweise Teil des Kernstapels und/oder Teil des Trägerbereichs.

In einer Weiterbildung ist die Pufferschichtfolge oder ein Teil der Pufferschichtfolge als zweite Halbleiterkontaktschicht ausgebildet. D.h. die Pufferschichtfolge erfüllt sowohl die Funktion des Gitterkonstantenausgleichs zwischen darüber und darunter angeordneten Schichten als auch die Funktion der zweiten Halbleiterkontaktschicht bzw. die entsprechende Schicht weist die sowohl die Merkmale der Pufferschichtfolge als auch die Merkmale der zweiten Halbleiterkontaktschicht auf.

In einer anderen Weiterbildung weist die metamorphe Pufferschichtfolge eine Abfolge von mindestens drei Schichten und beispielsweise höchstens zwanzig Schichten auf. Der metamorphe Puffer ist bevorzugt hoch n-dotiert oder hoch p-dotiert. Die Pufferschichtfolge ist beispielsweise aus InGaAs ausgebildet. Vorzugsweise weist die metamorphe Pufferschichtfolge eine Dotierstoffkonzentration größer als 5•10¹⁷ cm⁻³ und eine Schichtdicke oberhalb 0,5 µm und kleiner als 20 µm auf.

In einer Ausführungsform besteht die metamorphe Pufferschichtfolge aus mehreren InₓGa₁₋ₓAs-Schichten mit sich von Schicht zu Schicht unterscheidendem und/oder gleichbleibendem x.

Es versteht sich, dass sich die Gitterkonstante innerhalb des Puffers mindestens einmal ändert. In einer ersten Ausführungsform nimmt die Gitterkonstante ausgehend von einer untersten Schicht der Abfolge mit der zweiten Gitterkonstanten hin zu der obersten Schicht der Abfolge mit der ersten Gitterkonstante von Schicht zu Schicht beispielsweise zu.

Alternativ nimmt die Gitterkonstante ausgehend von der untersten Schicht der Abfolge von Schicht zu Schicht zuerst zu und dann ab oder auch zuerst ab und dann zu.

Die Zunahme oder die Abnahme der Gitterkonstanten über die gesamte Abfolge verläuft entweder stufenförmig oder linear oder auch in einer beliebigen anderen Form.

In einer weiteren Ausführungsform weist die III-V-Halbleiterleistungsdiode eine Substratschicht auf, wobei die Substratschicht als Teil des Trägerbereichs ausgebildet ist.

Die Substratschicht weist entweder die erste Gitterkonstante oder eine zweite Gitterkonstante auf. Die Substratschicht ist beispielsweise als GaAs- oder Ge-Substrat ausgebildet. In einer Weiterbildung bildet das Substrat die zweite Halbleiterkontaktschicht aus.

In einer anderen Ausführungsform besteht das Halbleiterdriftgebiet und/oder das erste Halbleiterkontaktgebiet und/oder das zweite Halbleiterkontaktgebiet aus GaAs oder aus InGaAs oder das Halbleiterdriftgebiet und/oder das erste Halbleiterkontaktgebiet und/oder das zweite Halbleiterkontaktgebiet weisen GaAs oder InGaAs auf.

Bevorzugt ist der erste Leitfähigkeitstyp p und der zweite Leitfähigkeitstyp n oder der erste Leitfähigkeitstyp ist n und der zweite Leitfähigkeitstyp p.

In einer anderen Ausführungsform sind das erste Halbleiterkontaktgebiet und/oder das zweite Halbleiterkontaktgebiet wannenförmig ausgebildet.

In einer anderen Ausführungsform ist der Rahmenbereich mit der Seitenfläche des Kernstapels stoffschlüssig verbunden.

Ein weiterer Gegenstand der Erfindung ist ein Herstellungsverfahren für eine stapelförmige hochsperrende III-V-Halbleiterleistungsdiode, wobei eine Halbleiterträgerschicht bereitgestellt wird.

Auf einer Oberseite der Halbleiterträgerschicht wird eine dielektrische Schicht abgeschieden.

Anschließend wird eine Maskenschicht mit mindestens einer Durchgangsöffnung auf einer Oberseite der dielektrischen Schicht hergestellt.

Nach dem Aufbringen der Maskenschicht wird in einem Ätzschritt die dielektrische Schicht in dem Bereich der mindestens einen Durchgangsöffnung der Maskenschicht entfernt und zwar bis zu der Halbleiterträgerschicht, so dass die dielektrische Schicht einen dielektrischen Rahmenbereich ausbildet.

Anschließend wird die Maskenschicht entfernt.

Nach dem Ätzschritt werden auf der freigelegten Oberseite der Halbleiterträgerschicht eine oder mehrere III-V-Halbleiterschichten nacheinander abgeschieden und in dem Metallisierungsschritt eine zumindest gebietsweise ausgebildete erste metallische Anschlusskontaktschicht auf einer Oberseite einer obersten abgeschiedenen III-V-Halbleiterschicht und eine zweite metallische Anschlusskontaktschicht unterhalb einer untersten abgeschiedenen III-V-Halbleiterschicht aufgebracht.

Es versteht sich, dass die genannte Reihenfolge nicht unbedingt die zeitliche Reihenfolge der einzelnen Verfahrensschritte vorgibt. Wesentliche zeitliche Zusammenhänge sind deshalb ausdrücklich genannt.

Auch verseht es sich, dass das Verfahren geeignet ist, eine III-V-Halbleiterleistungsdiode der vorbeschriebenen Art herzustellen und dass die vorstehenden Anmerkungen hinsichtlich der III-V-Halbleiterleistungsdiode entsprechend auch für das erfindungsgemäße Herstellungsverfahren gelten.

Weiterhin versteht es sich, dass das Herstellungsverfahren bevorzugt auf Wafer-Ebene ausgeführt wird, also eine Vielzahl von III-V-Halbleiterleistungsdioden matrixartig nebeneinander hergestellt werden. Anschließend werden die Bauelemente durch Sägen im Bereich des dielektrischen Rahmenbereichs vereinzelt und weisen nach dem Vereinzeln eine Seitenwandpassivierung auf.

Aufgrund der unterschiedlichen Materialien von dielektrischer Schicht und Halbleiterträgerschicht, also eines dielektrischen Materials im Vergleich zu einem III-V-Halbleitermaterial, kann der Ätzschritt, z.B. ein Trockenätzschritt oder ein nasschemischer Ätzschritt, mit einer hohen Selektivität ausgeführt werden, wodurch kein oder nur ein sehr geringer Abtrag der Halbleiterträgerschicht, also des Trägerbereichs erfolgt.

Die Ausnehmung in der dielektrischen Schicht wird anschließend mit einer oder mehreren Halbleiterschichten zumindest teilweise oder vollständig gefüllt, wodurch sich auf der Halbleiterträgerschicht ein von dem Rahmenbereich umschlossener Kernstapel aus Halbleiterschichten ausbildet.

In einer Ausführungsform umfasst der Kernstapel alle Halbleiterschichten der III-V-Halbleiterleistungsdiode, wobei die III-V-Halbleiterleistungsdiode durch Entfernen der gesamten Halbleiterträgerschicht quasi freigelegt wird. Alternativ umfasst der Kernstapel nur einen Teil der Halbleiterschichten der III-V-Halbleiterleistungsdiode, insbesondere das erste hochdotierte Halbleiterkontaktgebiet und gegebenenfalls auch das Driftgebiet, wobei weitere Schichten, beispielsweise das zweite Halbleiterkontaktgebiet von der Halbleiterträgerschicht umfasst sind.

In einer Weiterbildung ist eine abgeschiedene III-V-Halbleiterschicht ein Halbleiterdriftgebiet mit einem ersten oder einem zweiten Leitfähigkeitstyp und einer Dotierstoffkonzentration von 8•10^{u} - 1•10¹⁵ cm⁻³.

Ein erstes hochdotiertes Halbleiterkontaktgebiet des ersten Leitfähigkeitstyps mit einer Dotierstoffkonzentration von mindestens 1•10¹⁸ cm⁻³ wird bevorzugt entweder als eine der III-V-Halbleiterschichten durch Abscheiden zeitlich nach dem Abscheiden des Halbleiterdriftgebiets oder durch Einbringen von Dotierstoffen in einen oberen Teilbereich des Halbleiterdriftgebiets erzeugt.

In einer anderen Weiterbildung weist die Halbleiterträgerschicht eine Substratschicht auf, wobei die Substratschicht vor dem Metallisierungsschritt nicht, oder teilweise oder vollständig entfernt wird.

Ein zweites hochdotiertes Halbleiterkontaktgebiet des zweiten Leitfähigkeitstyps mit einer Dotierstoffkonzentration von mindestens 1•10¹⁸ cm⁻³ wird bevorzugt durch Abscheiden auf der Substratschicht oder durch Einbringen von Fremdatomen in einen Teil der Substratschicht oder durch Einbringen von Fremdatomen in die gesamte Substratschicht oder durch Bereitstellen einer Substratschicht mit einer Dotierstoffkonzentration von mindestens 5•10¹⁷ cm⁻³ als Teil der Halbleiterträgerschicht bereitgestellt.

Alternativ wird ein zweites hochdotiertes Halbleiterkontaktgebiet des zweiten Leitfähigkeitstyps mit einer Dotierstoffkonzentration von mindestens 1•10¹⁸ cm⁻³ nach einem Entfernen der Halbleiterträgerschicht durch Einbringen von Dotierstoffen in einen unteren Teilbereich des Halbleiterdriftgebiets erzeugt. In einer weiteren alternativen Ausführungsform wird ein zweites hochdotiertes Halbleiterkontaktgebiet eines zweiten Leitfähigkeitstyps mit einer Dotierstoffkonzentration von mindestens 1•10¹⁸ cm⁻³ nach dem Ätzschritt zur Öffnung der dielektrischen Schicht, also dem Erzeugen der Durchgangsöffnung und vor dem Abscheiden des Halbleiterdriftgebiets als III-V-Halbleiterschicht durch Abscheiden erzeugt.

In einer weiteren Ausführungsform wird in dem Metallisierungsschritt die zweite metallische Anschlusskontaktschicht auf einer Unterseite der zweiten Halbleiterkontaktschicht aufgebracht.

Die bereitgestellte Halbleiterträgerschicht weist bevorzugt ein GaAs-Substrat oder ein Ge-Substrat oder ein Si-Substrat auf.

In einer anderen Ausführungsform weist die dielektrische Schicht SiₓO_{y}, z.B. SiO₂, oder SiₓNi_{y} oder AlₓO_{y} oder TaₓO_{y} oder TiₓO_{y} oder HfₓO_{y} auf oder besteht aus SiₓO_{y} oder aus SiₓNi_{y} oder aus AlₓO_{y} oder aus TaₓO_{y} oder aus TiₓO_{y} oder aus HfₓO_{y}.

Das Abscheiden erfolgt bevorzugt mittels MOVPE oder mittels LPE oder mittels CVD.

In einer anderen Weiterbildung wird das erste Halbleiterkontaktgebiet mittels Implantation oder mittels Diffusion erzeugt. Es werden also Fremdatome durch Implantation oder Diffusion in eine andere Halbleiterschicht, z.B. das Driftgebiet, eingebracht und der entsprechende Bereich des Driftgebiets bildet dann das erste Halblelterkontaktgebiet aus bzw. wird zu dem ersten Halbleiterkontaktgebiet.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Querschnittansicht einer ersten Ausführungsform einer III-V-Halbleiterleistungsdiode,
- Figur 2: eine Aufsicht auf die erste Ausführungsform der III-V-Halbleiterleistungsdiode,
- Figur 3: eine Querschnittansicht einer zweiten Ausführungsform der III-V-Halbleiterleistungsdiode,
- Figur 4: eine Querschnittansicht einer dritten Ausführungsform der III-V-Halbleiterleistungsdiode,
- Figur 5: eine Querschnittansicht einer vierten Ausführungsform der III-V-Halbleiterleistungsdiode,
- Figur 6: eine Querschnittansicht einer fünften Ausführungsform der III-V-Halbleiterleistungsdiode,
- Figur 7: eine Querschnittansicht einer sechsten Ausführungsform der III-V-Halbleiterleistungsdiode,
- Figur 8: eine Querschnittansicht einer siebten Ausführungsform der III-V-Halbleiterleistungsdiode,
- Figur 9: eine Querschnittansicht einer achten Ausführungsform der III-V-Halbleiterleistungsdiode,
- Figur 10: eine Querschnittansicht einer neunten Ausführungsform der III-V-Halbleiterleistungsdiode,
- Figur 11: eine Querschnittansicht einer zehnten Ausführungsform der III-V-Halbleiterleistungsdiode,
- Figur 12: eine Querschnittansicht einer elften Ausführungsform der III-V-Halbleiterleistungsdiode,
- Figur 13: eine Ansicht erster Ausführungsform eines Herstellungsverfahrens einer III-V-Halbleiterleistungsdiode,
- Figur 14: eine Ansicht einer weiteren Ausführungsform eines Herstellungsverfahrens einer III-V-Halbleiterleistungsdiode
- Figur 15: eine Ansicht weiterer Ausführungsform eines Herstellungsverfahrens einer III-V-Halbleiterleistungsdiode.

Bei allen Abbildungen ist aus Gründen der Übersichtlichkeit jeweils nur eine Schnittansicht bzw. eine Querschnittsansicht einer stapelförmigen hochsperrenden III-V-Halbleiterleistungsdiode HLD dargestellt. Der Schichtstapel weist eine Oberseite und eine Unterseite auf.

Es sei angemerkt, dass alle in der Schnittansicht abgebildeten III-V-Halbleiterleistungsdioden HLD in einer Aufsicht entweder einen quadratischen oder einen rechteckigen oder einen runden Umfang oder auch einen rechteckigen Umfang mit abgerundeten Ecken aufweisen.

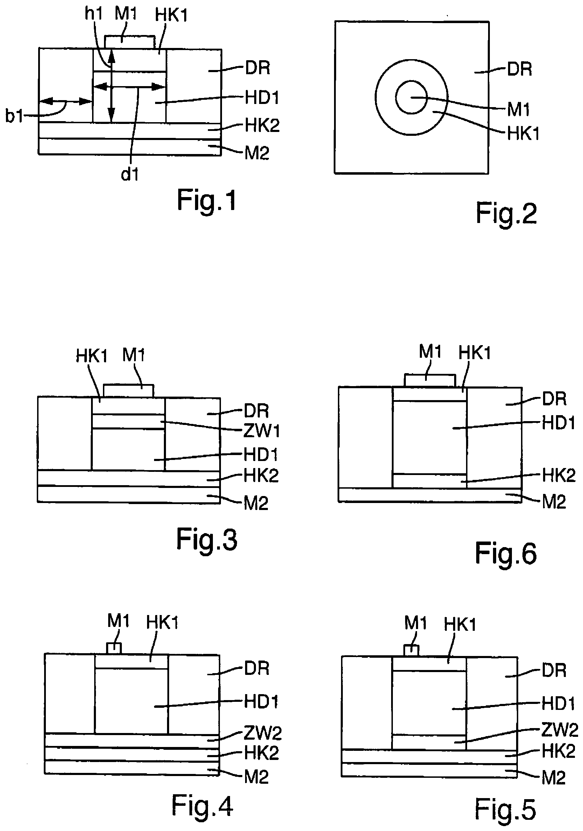

Die Abbildung der Figur 1 zeigt eine stapelförmige hochsperrende III-V-Halbleiterleistungsdiode HLD.

Die Halbleiterleistungsdiode HLD weist ein erstes hochdotiertes Halbleiterkontaktgebiet HK1 des ersten Leitfähigkeitstyps, ein Driftgebiet HD1 des ersten Leitfähigkeitstyps oder eines zweiten Leitfähigkeitstyps und ein zweites hochdotiertes Halbleiterkontaktgebiet HK2 des zweiten Leitfähigkeitstyps auf.

Das erste hochdotierte Halbleiterkontaktgebiet HK1 und das Driftgebiet bilden zusammen einen Kernstapel mit einer Oberseite, einer Unterseite, einer von der Oberseite zu der Unterseite reichenden Seitenfläche, einem Durchmesser d1 und einer Höhe h1 aus. Das erste Halbleiterkontaktgebiet HK1 und das Driftgebiet sind jeweils als Schicht des Kernstapels ausgebildet.

Die Oberseite des Kernstapels wird durch das erste hochdotierte Halbleiterkontaktgebiet gebildet und eine erste metallische Anschlusskontaktschicht M1 ist stoffschlüssig mit der Oberseite verbunden.

Die Seitenfläche des Kernstapels ist von einem dielektrischen Rahmenbereich DR umschlossen, wobei eine Oberseite des dielektrischen Rahmenbereichs DR mit der Oberseite des Kernstapels abschließt, also eine plane gemeinsame Oberfläche ausbildet.

Eine Unterseite des dielektrischen Rahmenbereichs DR und die Unterseite des Kernstapels schließen ebenfalls miteinander ab bzw. bilden ebenfalls eine plane gemeinsame untere Oberfläche aus. Der dielektrische Rahmenbereich DR weist entsprechend ebenfalls die Höhe h1 auf.

Außerdem weist der dielektrische Rahmenbereich DR eine Breite b1 auf, also eine den Kernstapel umgebende Wandstärke.

Das zweite Halbleiterkontaktgebiet HK2 ist schichtförmig mit einem Durchmesser oder einer Kantenlänge von d1+2·b1 ausgebildet und stoffschlüssig mit der gemeinsamen Unterseite des Kernstapels und des Rahmenbereichs DR verbunden.

Eine zweite metallische Anschlusskontaktschicht M2 überdeckt eine Unterseite des zweiten Halbleiterkontaktgebiets HK2.

Es versteht sich, dass die Halbleiterleistungsdiode HLD sowohl als n über p - Struktur ausgebildet sein kann, also mit n als erstem Leitfähigkeitstyp und p als zweiten Leitfähigkeitstyp, als auch als p über n - Struktur, also mit p als erstem Leitfähigkeitstyp und n als zweitem Leitfähigkeitstyp.

Das Halbleiterdriftgebiet HD1 weist entweder die erste oder die zweite Leitfähigkeit auf, ist also entweder schwach n-dotiert oder schwach p-dotiert. Entsprechend bildet sich der p-n Übergang der Halbleiterleistungsdiode entweder zwischen dem zweiten Halbleiterkontaktgebiet und dem Driftgebiet oder zwischen dem ersten Halbleiterkontaktgebiet und dem Driftgebiet aus.

Es versteht sich, dass die Begriffe "oben", "oberhalb", "unten" und "unterhalb" nur zur Anordnung der einzelnen Gebiete und Schichten relativ zueinander dienen und keine absolute Richtung angeben.

In der Abbildung der Figur 2 ist eine Aufsicht auf die III-V-Halbleiterleistungsiode der Figur 1 dargestellt.

Der dielektrische Rahmenbereich DR sowie die darunter liegenden Schichten, also das zweite Halbleiterkontaktgebiet HK2 und die zweite metallische Anschlusskontaktschicht M2, weisen jeweils einen quadratischen Umfang mit denselben Abmessungen auf.

Der Kernstapel, also das Driftgebiet HD1 und das erste Halbleiterkontaktgebiet HK1 weisen dagegen einen runden Umfang auf. Auch die erste metallische Anschlusskontaktschicht weist einen runden Umfang auf, wobei der Durchmesser der ersten metallischen Anschlusskontaktschicht M1 kleiner als der Durchmesser des ersten Halbleiterkontaktgebiets ist.

Der runde Umfang des Kernstapels lässt sich einfach herstellen und ist hinsichtlich der elektrischen Eigenschaften besonders vorteilhaft. Bei einer Vereinzelung durch Sägen ist dagegen ein quadratischer oder rechteckiger Umfang des gesamten Bauelements besonders einfach herstellbar.

In nicht dargestellten Ausführungsformen sind auch weitere Formen für den Umfang des Kernstapels und/oder des gesamten Bauelements möglich bzw. vorteilhaft, z.B. ein mehreckiger, z.B. achteckiger Umfang des Kernstapels oder des gesamten Bauelements.

Auch die erste metallische Anschlusskontaktschicht weist in weiteren nicht dargestellten Ausführungsformen bevorzugt andere Umfangsformen, z.B. mehreckige, auf.

In der Abbildung der Figur 3 ist eine weitere Ausführungsform dargestellt. Im Folgenden werden nur die Unterschiede zu der Abbildung der Figur 1 erläutert.

Die III-V-Halbleiterleistungsdiode HLD weist eine erste Zwischenschicht ZW1 auf, welche als Teil des Kernstapels zwischen dem ersten Halbleiterkontaktgebiet HK1 und dem Halbleiterdriftgebiet HD1 angeordnet ist.

In der Abbildung der Figur 4 ist eine weitere Ausführungsform dargestellt. Im Folgenden werden nur die Unterschiede zu der Abbildung der Figur 1 erläutert.

Die III-V-Halbleiterleistungsdiode HLD weist eine zweite Zwischenschicht ZW2 auf, welche zwischen dem zweiten Halbleiterkontaktgebiet HK2 und dem Halbleiterdriftgebiet HD1 angeordnet ist und stoffschlüssig mit der gemeinsamen Unterseite des Kernstapels und des dielektrischen Rahmenbereichs DR verbunden ist.

In der Abbildung der Figur 5 ist eine weitere Ausführungsform dargestellt. Im Folgenden werden nur die Unterschiede zu der Abbildung der Figur 4 erläutert.

Alternativ ist die zweite Zwischenschicht ZW2 als Teil des Kernstapels, insbesondere als unterste Schicht des Kernstapels ausgebildet.

In der Abbildung der Figur 6 ist eine weitere Ausführungsform dargestellt. Im Folgenden werden nur die Unterschiede zu der Abbildung der Figur 1 erläutert.

Das zweite Halbleiterkontaktgebiet ist ebenfalls als Teil des Kernstapels, nämlich als unterste Schicht des Kernstapels ausgebildet. Die zweite metallische Anschlusskontaktschicht M2 ist stoffschlüssig mit der aus der Unterseite des Kernstapels und der Unterseite des dielektrischen Randbereichs gebildeten gemeinsamen Unterseite verbunden.

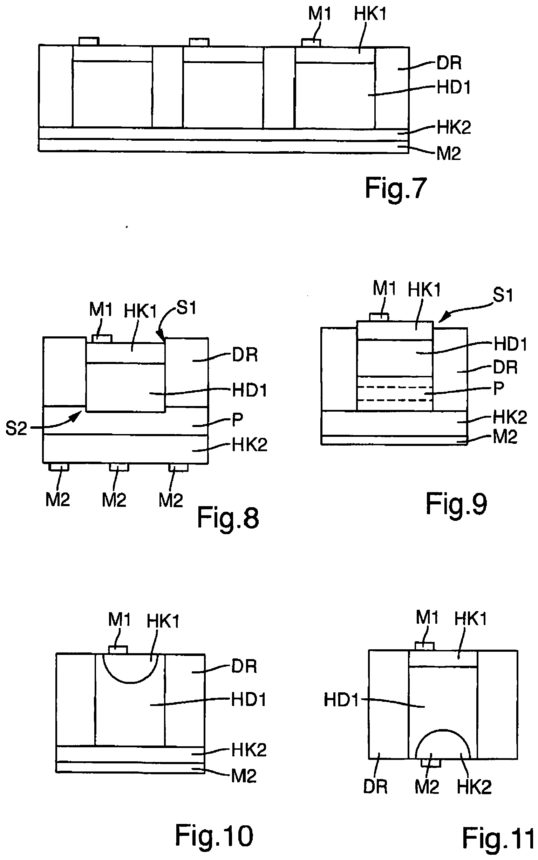

In der Abbildung der Figur 7 ist eine weitere Ausführungsform dargestellt. Im Folgenden werden nur die Unterschiede zu der Abbildung der Figur 1 erläutert.

Vor dem Vereinzeln sind mehrere III-V-Halbleiterleistungsdioden HLD durch einen gemeinsamen dielektrischen Rahmenbereich DR verbunden. Außerdem sind die Halbleiterleistungsdioden HLD in dem dargestellten Ausführungsbeispiel noch durch ein gemeinsames zweite Halbleiterkontaktgebiet HK2 und eine gemeinsame zweite metallische Anschlusskontaktschicht verbunden.

Es versteht sich, dass auch die weiteren Ausführungsformen gemeinsam auf einem Wafer herstellbar sind und entsprechende gemeinsame Strukturen aufweisen. Neben dem Rahmenbereich DR ist es insbesondere vorteilhaft alle unterhalb des Rahmenbereichs DR und des Kernstapels angeordneten Schichten als gemeinsame Schichten herzustellen. Vereinzelt wird bevorzugt durch einen einzigen Sägeschritt.

In der Abbildung der Figur 8 ist eine weitere Ausführungsform dargestellt. Im Folgenden werden nur die Unterschiede zu der Abbildung der Figur 1 erläutert.

Die III-V-Halbleiterleistungsdiode HLD weist eine Pufferschichtfolge P auf, wobei die Pufferschichtfolge P unterhalb des dielektrischen Rahmenbereich DR und des Kernstapels und oberhalb des zweiten Halbleiterkontaktgebiets HK2 angeordnet ist.

Der Kernstapel bildet an der Oberseite eine zu dem dielektrischen Rahmenbereich DR hin ansteigende erste Stufe S1 und zu der Unterseite des dielektrischen Rahmenbereichs DR hin eine absteigende zweite Stufe S2 aus. Die Stufen sind beispielsweise jeweils aufgrund eines Ätzprozesses während der Herstellung entstanden.

Die zweite metallische Anschlusskontaktschicht M2 ist fingerförmig ausgebildet, weist also mehrere fingerförmige und beispielsweise parallel verlaufende Abschnitte auf, welche bevorzugt durch einen weiteren quer verlaufenden Abschnitt miteinander verbunden sind.

In der Abbildung der Figur 9 ist eine weitere Ausführungsform dargestellt. Im Folgenden werden nur die Unterschiede zu der Abbildung der Figur 8 erläutert.

Alternativ ist die Pufferschichtfolge P als Teil des Kernstapels ausgebildet. Die Pufferschichtfolge weist beispielsweise drei Schichten mit jeweils unterschiedlicher Gitterkonstanten auf (gestrichelt dargestellt).

Der Kernstapel weist eine zu der Oberseite des dielektrischen Rahmenbereichs abfallende erste Stufe auf, während die Unterseiten des dielektrischen Rahmenbereichs und des Kernstapels in diesem dargestellten Ausführungsbeispiel miteinander abschließen.

Die zweite metallische Anschlusskontaktschicht ist flächig ausgebildet.

In der Abbildung der Figur 10 ist eine weitere Ausführungsform dargestellt. Im Folgenden werden nur die Unterschiede zu der Abbildung der Figur 1 erläutert.

Das erste Halbleiterkontaktgebiet HK1 ist wannenförmig ausgebildet und erstreckt sich von der Oberseite des Kernstapels in den Kernstapel, hier in die Halbleiterdriftschicht HD1, hinein.

In der Abbildung der Figur 11 ist eine weitere Ausführungsform dargestellt. Im Folgenden werden nur die Unterschiede zu der Abbildung der Figur 1 erläutert.

Alternativ ist das zweite Halbleiterkontaktgebiet HK2 wannenförmig ausgebildet und erstreckt sich von der Unterseite des Kernstapels in den Kernstapel hinein.

In einer nicht dargestellten Weiterbildung sind die beiden Halbleiterkontaktgebiete HK1 und HK2 wannenförmig in den Kernstapel hineinragend ausgebildet.

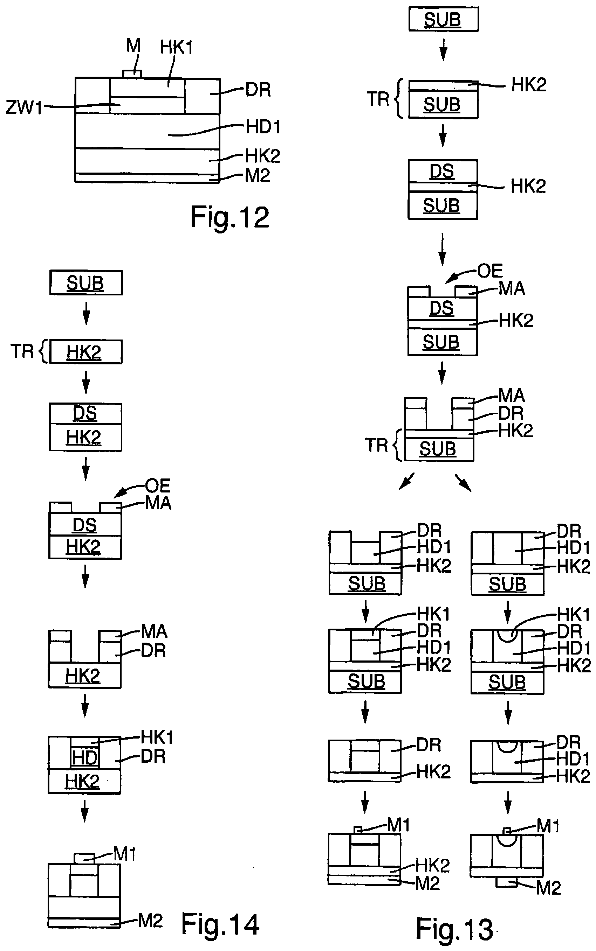

In der Abbildung der Figur 12 ist eine weitere Ausführungsform dargestellt. Im Folgenden werden nur die Unterschiede zu der Abbildung der Figur 1 erläutert.

Der Kernstapel der hochsperrenden III-V-Halbleiterleistungsdiode HLD weist das erste Halbleiterkontaktgebiet HK1 sowie die erste Halbleiterzwischenschicht ZW1 auf. Das Driftgebiet HD1 bildet zusammen mit dem zweiten Halbleiterkontaktgebiet HK2 und der zweiten metallischen Anschlusskontaktschicht M2 den Trägerbereich aus.

In der Abbildung der Figur 13 sind erste erfindungsgemäße Ausführungsformen eines Herstellungsverfahrens einer hochsperrenden III-V-Halbleiterleistungsdiode HLD schematisch dargestellt.

Auf einer Substratschicht SUB wird eine hochdotierte zweite Halbleiterkontaktschicht HK2, z.B. mittels MOVPE oder LPE oder CVD, abgeschieden, wobei die Substratschicht SUB zusammen mit der zweiten Halbleiterkontaktschicht HK2 als eine Halbleiterträgerschicht TR dienen.

Auf einer Oberseite der Halbleiterträgerschicht TR wird eine dielektrische Schicht DS, z.B. eine SiO₂-Schicht, abgeschieden. Anschließend wird auf einer Oberseite der dielektrischen Schicht DS eine Maskenschicht MA mit mindestens einer Durchgangsöffnung OE aufgebracht.

In einem Ätzschritt wird die dielektrische Schicht DS in dem Bereich der mindestens einen Durchgangsöffnung OE der Maskenschicht MA zumindest bis zu der Halbleiterträgerschicht TR entfernt. Es versteht sich, dass durch den Ätzprozess gegebenenfalls auch ein Teil der Halbleiterträgerschicht TR, hier also der zweiten Halbleiterkontaktschicht HK2 weggeätzt wird. Der nach dem Ätzschritt verbliebene Teil der dielektrischen Schicht DS bildet einen dielektrischen Rahmenbereich DR.

Die Maskenschicht MA wird wieder entfernt.

Auf der freigelegten Oberseite der Halbleiterträgerschicht TR, hier also der zweiten Halbleiterkontaktschicht HK2 wird eine Halbleiterdriftschicht HD1 abgeschieden, wobel eine aufgewachsene Schichtdicke der Halbleiterdriftschicht HD1 im Vergleich zu einer Höhe des dielektrischen Rahmenbereichs entweder kleiner (linker Pfad der Figur 13) oder gleich (rechter Pfad der Figur 13) oder größer (nicht dargestellt) ausfällt.

Anschließend wird eine erste hochdotierte Halbleiterkontaktschicht HK1 entweder auf einer Oberseite der Halbleiterdriftschicht HD1 abgeschieden (linker Pfad der Figur 13) oder durch Einbringen von Dotierstoffen in einen sich an eine Oberseite der Halbleiterdriftschicht HD1 anschließenden Bereich der Halbleiterdriftschicht HD1 erzeugt (rechter Pfad der Figur 13).

Anschließend wird die Substratschicht SUB entfernt.

In einem Metallisierungsschritt wird eine zumindest gebietsweise ausgebildete erste metallische Anschlusskontaktschicht M1 auf einer Oberseite der ersten Halbleiterkontaktschicht HK1 und eine zweite metallische Anschlusskontaktschicht M2 auf der Unterseite der zweiten Halbleiterkontaktschicht HK2 aufgebracht.

In der Abbildung der Figur 14 ist eine weitere erfindungsgemäße Ausführungsform des Herstellungsverfahrens einer hochsperrenden III-V-Halbleiterleistungsdiode HLD schematisch dargestellt. Im Folgenden werden nur die Unterschiede zu der Abbildung der Figur 13 erläutert.

Die bereitgestellte Substratschicht wird durch einbringen von Dotierstoffen in eine hochdotierte Halbleiterkontaktschicht HK2 umgewandelt und dient als Halbleiterträgerschicht TR.

Entsprechend fällt der Verfahrensschritt des Entfernens des Substrats weg, wobei die Substratschicht In einer Weiterbildung gedünnt wird.

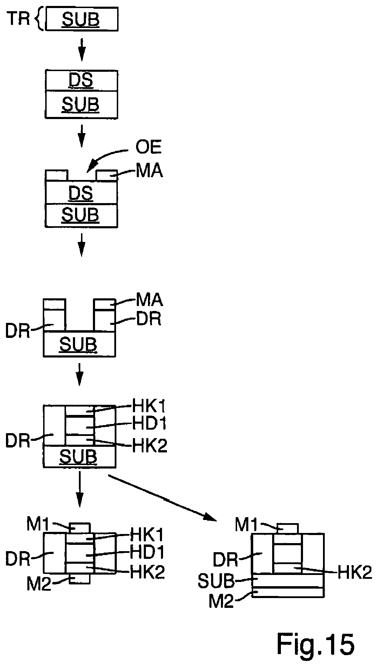

In der Abbildung der Figur 15 sind weitere erfindungsgemäße Ausführungsformen eines Herstellungsverfahrens einer hochsperrenden III-V-Halbleiterleistungsdiode HLD schematisch dargestellt

Die Substratschicht SUB dient als Trägerschicht TR. Nach dem Masken- und Ätzprozess werden auf dem freigelegten Oberflächenbereich der Trägerschicht TR, also dem Substrat SUB, nacheinander die zweite Halbleiterkontaktschicht HK2, das Driftgebiet HD1 und die erste Halbleiterkontaktschicht HK1 aufgewachsen.

Anschließend wird die Trägerschicht TR, also die Substratschicht SUB, entfernt und die erste und zweite metallische Anschlusskontaktschicht aufgebracht (linker Pfad der Figur 15).

Alternativ wird die Substratschicht SUB nicht oder nur teilweise entfernt (gedünnt) und die zweite metallische Anschlusskontaktschicht M2 wird auf einer Unterseite der Substratschicht SUB aufgebracht (rechter Pfad der Figur 15).

## Patentansprüche

1. Stapelförmige hochsperrende III-V-Halbleiterleistungsdiode (HLD) aufweisend
- ein erstes hochdotiertes Halbleiterkontaktgebiet (HK1) eines ersten Leitfähigkeitstyps mit einer Dotierstoffkonzentration von mindestens 1•10¹⁸ cm⁻³ und mit einer ersten Gitterkonstanten,
- ein unterhalb des ersten Halbleiterkontaktgebiets (HK1) angeordnetes niedrig dotiertes Halbleiterdriftgebiet (HD1) des ersten Leitfähigkeitstyps oder eines zweiten Leitfähigkeitstyps mit einer Dotierstoffkonzentration von 8•10¹¹ - 1•10¹⁵ cm⁻³, mit der erste Gitterkonstanten und einer Schichtdicke von 10 µm - 200 µm,
- ein unterhalb des Halbleiterdriftgebiets (HD1) angeordnetes hochdotiertes zweites Halbleiterkontaktgebiet (HK2) des zweiten Leitfähigkeitstyps mit einer Dotierstoffkonzentration von mindestens 5•10¹⁷ cm⁻³ und mit der ersten Gitterkonstanten oder einer zweiten Gitterkonstanten,
- eine zumindest gebietsweise ausgebildete und stoffschlüssig mit einer Oberseite des ersten Halbleiterkontaktgebiets (HK1) verbundene erste metallische Anschlusskontaktschicht (M1),
- eine zumindest gebietsweise ausgebildete und unterhalb einer Unterseite des zweiten Halbleiterkontaktgebiets (HK2) angeordnete zweite metallisches Anschlusskontaktschicht (M2), wobei
- zumindest das erste Halbleiterkontaktgebiet (HK1) einen Kernstapel mit einer Oberseite, einer Unterseite und einer sich von der Oberseite bis zu der Unterseite erstreckenden Seitenfläche ausbildet,
**dadurch gekennzeichnet, dass**
- die III-V-Halbleiterleistungsdiode (HLD) einen den Kernstapel entlang der Seitenfläche umschließenden dielektrischen Rahmenbereich (DR) mit einer Oberseite und einer Unterseite aufweist, wobei
- die Oberseite des Kernstapels mit der Oberseite des dielektrischen Rahmenbereichs (DR) abschließt oder zu der Oberseite des dielektrischen Rahmenbereichs (DR) eine erste Stufe (S1) ausbildet,
- die Unterseite des Kernstapels mit der Unterseite des dielektrischen Rahmenbereichs (DR) abschließt oder zu der Unterseite des dielektrischen Rahmenbereichs (DR) eine zweite Stufe (S2) ausbildet und
- unterhalb des ersten Halbleiterkontaktgebiets (HK1) angeordnete Halbleitergebiete der III-V-Halbleiterleistungsdiode (HLD) jeweils entweder von dem Kernstapel umfasst sind oder einen Trägerbereich ausbilden einen Trägerbereich ausbilden, wobei
- der Trägerbereich unterhalb des Kernstapels und des Rahmenbereichs angeordnet und mit einer gemeinsamen Unterseite, gebildet aus der Unterseite des dielektrischen Rahmenbereichs (DR) und der Unterseite des Kernstapels, stoffschlüssig verbunden ist.

2. Hochsperrende III-V-Halbleiterleistungsdiode (HLD) nach Anspruch 1, **dadurch gekennzeichnet, dass** der dielektrische Rahmenbereich (DR) aus SiₓO_{y} oder aus SiₓN_{y} oder aus AlₓO_{y} oder aus TaₓO_{y} oder aus TiₓO_{y} oder aus HfₓO_{y} besteht oder SiₓO_{y} oder SiₓN_{y} oder AlₓO_{y} oder TaₓO_{y} oder TiₓO_{y} oder HfₓO_{y} aufweist.

3. Hochsperrende III-V-Halbleiterleistungsdiode (HLD) nach Anspruch 1 oder 2, **dadurch gekennzeichnet, dass** die III-V-Halbleiterleistungsdiode (HDL) zwischen dem ersten Halbleiterkontaktgebiet (HK1) und dem Halbleiterdriftgebiet (HD1) eine Halbleiterzwischenschicht (ZW1) des ersten Leitfähigkeitstyps mit einer Dotierstoffkonzentration von 8•10¹² - 1•10¹⁶ cm⁻³ aufweist.

4. Hochsperrende III-V-Halbleiterleistungsdiode (HLD) nach einem der vorstehenden Ansprüche, **dadurch gekennzeichnet, dass** die III-V-Halbleiterleistungsdiode (HLD) zwischen dem zweiten Halbleiterkontaktgebiet (HK2) und dem Halbleiterdriftgebiet (HD1) eine Halbleiterzwischenschicht (ZW2) des zweiten Leitfähigkeitstyps mit einer Dotierstoffkonzentration von 8•10^{12 -} 1•10¹⁶ cm⁻³ aufweist.

5. Hochsperrende III-V-Halbleiterleistungsdiode (HLD) nach einem der vorstehenden Ansprüche, **dadurch gekennzeichnet, dass** die III-V-Halbleiterleistungsdiode (HLD) eine hochdotierte metamorphe Pufferschichtfolge (P) aufweist, wobei die metamorphe Pufferschichtschichtfolge (P) zwischen dem Halbleiterdrfftgebiet (HD1) und dem zweiten Halbleiterkontaktgebiet (HK2) angeordnet ist, eine Dotierstoffkonzentration größer als 5•10¹⁷ cm⁻³ und einer Schichtdicke oberhalb 0,5 µm und kleiner als 20 µm aufweist, von dem ersten Leitfähigkeitstyp oder dem zweiten Leitfähigkeitstyp ist und an einer dem Halbleiterdriftgebiet (HD1) zugewandten Oberseite die erste Gitterkonstante und an einer dem zweiten Halbleiterkontaktgebiet (HK2) zugewandten Unterseite die zweite Gitterkonstante aufweist und das zweite Halbleiterkontaktgebiet (HK2) die zweite Gitterkonstante aufweist.

6. Hochsperrende III-V-Halbleiterleistungsdiode (HLD) nach Anspruch 4, **dadurch gekennzeichnet, dass** die Pufferschichtfolge (P) Teil des Kernstapels und/oder Teil des Trägerbereichs ist.

7. Hochsperrende III-V-Halbleiterleistungsdiode (HLD) nach einem der vorstehenden Ansprüche, **dadurch gekennzeichnet, dass** die III-V-Halbleiterleistungsdiode (HDL) eine Substratschicht (SUB) aufweist, wobei die Substratschicht (SUB) als Teil des Trägerbereichs ausgebildet ist.

8. Hochsperrende III-V-Halbleiterleistungsdiode (HLD) nach einem der vorstehenden Ansprüche, **dadurch gekennzeichnet, dass** das Halbleiterdriftgebiet (HD1) und/oder das erste Halbleiterkontaktgebiet (HK1) und/oder das zweite Halbleiterkontaktgebiet (HK2) aus GaAs oder aus InGaAs bestehen oder das Halbleiterdriftgebiet (HD1) und/oder das erste Halbleiterkontaktgebiet (HK1) und/oder das zweite Halbleiterkontaktgebiet (HK2) GaAs oder InGaAs aufweisen.

9. Hochsperrende III-V-Halbleiterleistungsdiode (HLD) nach einem der vorstehenden Ansprüche, **dadurch gekennzeichnet, dass** der erste Leitfähigkeitstyp p und der zweite Leitfähigkeitstyp n ist oder der erste Leitfähigkeitstyp n und der zweite Leitfähigkeitstyp p ist.

10. Hochsperrende III-V-Halbleiterleistungsdiode (HLD) nach einem der vorstehenden Ansprüche, **dadurch gekennzeichnet, dass** das erste Halbleiterkontaktgebiet (HK1) und/oder das zweite Halbleiterkontaktgebiet (HK2) wannenförmig ausgebildet ist.

11. Hochsperrende III-V-Halbleiterleistungsdiode (HLD) nach einem der vorstehenden Ansprüche, **dadurch gekennzeichnet, dass** der Rahmenbereich (DR) mit der Seitenfläche des Kernstapels stoffschlüssig verbunden ist.

12. Herstellungsverfahren für eine stapelförmige hochsperrende III-V-Halbleiterleistungsdiode, wobei
- eine Halbleiterträgerschicht (TR) bereitgestellt wird,
- eine dielektrische Schicht (DS) auf einer Oberseite der Halbleiterträgerschicht (TR) abgeschieden wird,
- eine Maskenschicht (MA) mit mindestens einer Durchgangsöffnung (OE) auf einer Oberseite der dielektrischen Schicht (DS) aufgebracht wird,
- nach dem Aufbringen der Maskenschicht in einem Ätzschritt die dielektrische Schicht (DS) in dem Bereich der mindestens einen Durchgangsöffnung (OE) der Maskenschicht (MA) bis zu der Halbleiterträgerschicht (TR) entfernt wird, um einen dielektrischen Rahmenbereich (DR) auszubilden,
- die Maskenschicht (MA) entfernt wird,
- nach dem Ätzschritt auf der freigelegten Oberseite der Halbleiterträgerschicht (TR) eine oder mehrere III-V-Halbleiterschichten nacheinander abgeschieden werden,
- in dem Metallisierungsschritt eine zumindest gebietsweise ausgebildete erste metallische Anschlusskontaktschicht auf einer Oberseite einer obersten abgeschiedenen III-V-Halbleiterschicht und eine zweite metallische Anschlusskontaktschicht unterhalb einer untersten abgeschiedenen III-V-Halbleiterschicht aufgebracht wird.

13. Herstellungsverfahren nach Anspruch 12, **dadurch gekennzeichnet, dass** eine abgeschiedene II-V-Halbleiterschicht ein Halbleiterdriftgebiet (HD1) mit einem ersten oder einem zweiten Leitfähigkeitstyp und einer Dotierstoffkonzentration von 8•10¹¹ - 1•10¹⁵ cm⁻³ ist.

14. Herstellungsverfahren nach Anspruch 13, **dadurch gekennzeichnet, dass** ein erstes hochdotierter Halbleiterkontaktgebiet (HK1) des ersten Leitfähigkeitstyps mit einer Dotierstoffkonzentration von mindestens 1•10¹⁸ cm⁻³ entweder als eine der III-V-Halbleiterschichten durch Abscheiden zeitlich nach dem Abscheiden des Halbleiterdriftgebiets (HD1) oder durch Einbringen von Dotierstoffen in einen oberen Teilbereich des Halbleiterdriftgebiets (HD1) erzeugt wird.

15. Herstellungsverfahren nach einem der Ansprüche 12 bis 14, **dadurch gekennzeichnet, dass** die Halbleiterträgerschicht eine Substratschicht (SUB) umfasst, wobei die Substratschicht (SUB) vor dem Metallisierungsschritt nicht, teilweise oder vollständig entfernt wird.

16. Herstellungsverfahren nach Anspruch 15, **dadurch gekennzeichnet, dass** ein zweites hochdotiertes Halbleiterkontaktgebiet (HK2) des zweiten Leitfähigkeitstyps mit einer Dotierstoffkonzentration von mindestens 5•10¹⁷ cm⁻³ durch Abscheiden auf der Substratschicht (SUB) oder durch Einbringen von Fremdatomen in einen Teil der Substratschicht (SUB) oder durch Einbringen von Fremdatomen in die gesamte Substratschicht (SUB) oder durch Bereitstellen einer Substratschicht mit einer Dotierstoffkonzentration von mindestens 5•10¹⁷ cm⁻³ als Teil der Halbleiterträgerschicht (TR) bereitgestellt wird.

17. Herstellungsverfahren nach einem der Ansprüche 12 bis 15, **dadurch gekennzeichnet, dass** ein zweites hochdotiertes Halbleiterkontaktgebiet (HK2) des zweiten Leitfähigkeitstyps mit einer Dotierstoffkonzentration von mindestens 5•10¹⁷ cm⁻³ nach einem Entfernen der Halbleiterträgerschicht (TR) durch Einbringen von Dotierstoffen in einen unteren Teilbereich des Halbleiterdriftgebiets (HD1) erzeugt wird.

18. Herstellungsverfahren nach einem der Ansprüche 12 bis 15, **dadurch gekennzeichnet, dass** ein zweites hochdotiertes Halbleiterkontaktgebiet (HK2) des zweiten Leitfähigkeitstyps mit einer Dotierstoffkonzentration von mindestens 5•10¹⁷ cm⁻³ nach dem Ätzschritt zur Öffnung der dielektrischen Schicht (DS) und vor dem Abscheiden des Halbleiterdriftgebiets (HD1) als III-V-Halbleiterschicht durch Abscheiden erzeugt wird.

19. Herstellungsverfahren nach einem der Ansprüche 16 bis 18, **dadurch gekennzeichnet, dass** in dem Metallisierungsschritt die zweite metallische Anschlusskontaktschicht auf einer Unterseite der zweiten Halbleiterkontaktschicht (HK2) aufgebracht wird.

20. Herstellungsverfahren nach einem der Ansprüche 12 bis 19, **dadurch gekennzeichnet, dass** die bereitgestellte Halbleiterträgerschicht (TR) ein GaAs-Substrat oder ein Ge-Substrat oder ein Si-Substrat aufweist.

21. Herstellungsverfahren nach einem der Ansprüche 12 bis 20, **dadurch gekennzeichnet, dass** die dielektrische Schicht (DS) SiₓO_{y} oder SiₓNi_{y} oder AlₓO_{y} oder TaₓO_{y} oder TiₓO_{y} oder HfₓO_{y} umfasst oder aus SiₓO_{y} oder aus SiₓNi_{y} oder aus AlₓO_{y} oder aus TaₓO_{y} oder aus TiₓO_{y} oder aus HfₓO_{y} besteht.

22. Herstellungsverfahren nach einem der Ansprüche 12 bis 21, **dadurch gekennzeichnet, dass** das Abscheiden mittels MOVPE oder mittels LPE oder mittels CVD erfolgt.

23. Herstellungsverfahren nach einem der Ansprüche 12 bis 22, **dadurch gekennzeichnet, dass** das erste Halbleiterkontaktgebiet mittels Implantation oder mittels Diffusion erzeugt wird.

24. Herstellungsverfahren nach einem der Ansprüche 12 bis 23, **dadurch gekennzeichnet, dass** eine hochsperrende III-V-Halbleiterleistungsdiode (HLD) gemäß einem der Ansprüche 1 bis 11 hergestellt wird.
